**Europäisches Patentamt**

**European Patent Office**

**Office européen des brevets**

(19)

(11) Numéro de publication : **0 217 713 B1**

(12) # FASCICULE DE BREVET EUROPEEN

(45) Date de publication du fascicule du brevet :
27.03.91 Bulletin 91/13

(51) Int. Cl.⁵ : **H03L 1/04, H03H 9/05**

(21) Numéro de dépôt : **86402090.4**

(22) Date de dépôt : **24.09.86**

---

(54) **Oscillateur thermostaté miniature.**

---

(30) Priorité : **24.09.85 FR 8514141**

(43) Date de publication de la demande :
**08.04.87 Bulletin 87/15**

(45) Mention de la délivrance du brevet :
**27.03.91 Bulletin 91/13**

(84) Etats contractants désignés :
**CH DE FR GB LI**

(56) Documents cités :
**AU-B- 461 767
FR-A- 2 239 048
PATENTS ABSTRACTS OF JAPAN, vol. 1, no.
148, 29 novembre 1977, page 7713 E 77 ; &
JP-A-52 89 090 (CITIZEN TOKEI K.K.) 26-
07-1977
PATENTS ABSTRACTS OF JAPAN, vol. 4, no.
56, 25 avril 1980, page 160 E 8 ; & JP-A-55 27
743 (SUWA SEIKOSHA K.K.) 28-02-1980
PATENTS ABSTRACTS OF JAPAN, vol. 8, no.
281, 21 décembre 1984, page 127 E 286 ; &
JP-A-59 149 406 (SUWA SEIKOSHA K.K.) 27-
08-1984**

(73) Titulaire : **CENTRE NATIONAL DE LA
RECHERCHE SCIENTIFIQUE (CNRS)
15, Quai Anatole France
F-75007 Paris (FR)**
Titulaire : **CENTRE NATIONAL D'ETUDES
SPATIALES
2 Place Maurice-Quentin
F-75039 Paris Cedex 01 (FR)**

(72) Inventeur : **Hauden, Daniel
7 rue du Refuge
F-25000 Besançon (FR)**
Inventeur : **Marianneau, Gilles
9 rue du Polygone
F-25000 Besançon (FR)**

(74) Mandataire : **Thévenet, Jean-Bruno et al
Cabinet BEAU DE LOMENIE 55 rue
d'Amsterdam
F-75008 Paris (FR)**

---

Jouve, 18, rue Saint-Denis, 75001 PARIS

## Description

La présente invention a pour objet un oscillateur thermostaté miniature, comprenant un support de montage, un résonateur piézoélectrique, des circuits électroniques de régulation de la tension d'alimentation de l'oscillateur, des circuits électroniques d'entretien et d'amplification des oscillations du résonateur, et des moyens de régulation de la température du résonateur piézoélectrique, ces derniers étant disposés au voisinage immédiat du résonateur.

On connait divers types d'oscillateurs réalisés à partir de résonateurs piézoélectriques tels que des résonateurs à quartz et destinés à constituer notamment des éléments de référence de fréquence de haute précision et de grande stabilité. De tels oscillateurs sont généralement placés dans des enceintes thermostatées afin de limiter les variations de température auxquelles est soumis le résonateur et ainsi éviter des fluctuations ou des dérives du signal de sortie de l'oscillateur. On peut réaliser de la sorte des dispositifs fiables et de grande qualité. Toutefois, le poids et l'encombrement dûs à l'ensemble des circuits de l'oscillateur et surtout au thermostat ne sont pas négligeables et il est difficile de réaliser des oscillateurs à cristal piézoélectrique qui soient à la fois de petites dimensions et de bonne qualité, bien qu'il soit possible de disposer de résonateurs miniaturisés.

En particulier, un inconvénient des dispositifs de l'art antérieur réside dans le fait que le capteur de température et les éléments de chauffage du thermostat sont relativement éloignés l'un de l'autre de sorte qu'il se produit un gradient de température important qui réduit l'efficacité du thermostat ou implique une consommation d'énergie relativement élevée qui empêche de réduire de façon sensible l'encombrement du dispositif. On connaît par le document FR-A-2239 048 un circuit oscillateur, notamment pour des montres ou pendules à quartz, comprenant un cristal piézoélectrique ou ferroélectrique, en particulier en forme de diapason, qui est en contact thermique avec un dispositif semi-conducteur qui constitue un dispositif commandé chauffant ou refroidisseur, le dispositif semi-conducteur étant disposé entre le socle du boîtier et le point de fixation du cristal oscillant, ce qui constitue un mode de réalisation assez rustique qui n'est pas optimisé du point de vue mécanique aussi bien que du point de vue des échanges thermiques, et est peu adapté à des oscillateurs de haute précision comprenant des résonateurs présentant d'autres formes que des diapasons.

On connaît par ailleurs par le document JP-A-52 89090 un oscillateur pour montre tel que le boîtier du résonateur porte sur une de ses faces un circuit semi-conducteur et se trouve situé dans une ouverture de la plaque de base du circuit imprimé. L'ensemble oscillateur-circuit semi-conducteur est rattaché à la plaquette de circuit imprimé par des languettes formant également conducteurs électriques, les languettes permettant d'absorber des différences de dilatation. Un tel oscillateur qui montre un boîtier métallique rattaché à la plaque de base du circuit imprimé exclusivement par des connexions de liaison électrique, et ne comporte pas de moyens de régulation de température, ne peut constituer un oscillateur de haute précision.

La présente invention vise à remédier aux inconvénients précités et à permettre la réalisation d'un oscillateur qui, tout en étant de petites dimensions, présente une stabilité élevée ainsi qu'une faible consommation.

Ces buts sont atteints grâce à un oscillateur thermostaté miniature caractérisé en ce que le support de montage comprend un circuit imprimé muni d'une ouverture sur le rebord de laquelle est fixé en un nombre de points réduit un support secondaire isolant électriquement sur lequel sont fixés d'une part le résonateur piézoélectrique et d'autre part un circuit intégré comprenant sous forme intégrée sur une même pastille les éléments essentiels des circuits électroniques de régulation de la tension d'alimentation de l'oscillateur, des circuits électroniques d'entretien et d'amplification des oscillations du résonateur et des moyens de régulation de la température du résonateur piézoélectrique.

Selon cette disposition, il existe un minimum d'échanges thermiques entre le circuit imprimé et le support secondaire, et le fait que les éléments essentiels des moyens de régulation de la température du résonateur soient intégrés dans un circuit disposé à proximité immédiate du résonateur réduit les gradients de température et par là-même permet une régulation efficace avec un meilleur rendement qui autorise la présentation des circuits électroniques sous une forme intégrée miniaturisée. Par ailleurs, les déperditions de chaleur dans les circuits électroniques de régulation de la tension d'alimentation de l'oscillateur et les circuits électroniques d'entretien et d'amplification des oscillations du résonateur sont effectuées pour l'essentiel au sein du circuit intégré et par là-même participent à la mise en température du résonateur ce qui réduit les pertes d'énergie, tout en étant prises en compte par les moyens de régulation de la température qui sont également intégrés dans le circuit prédiffusé, ce qui garantit un bon rendement et une grande précision dans la régulation. Le circuit intégré est avantageusement constitué par un circuit prédiffusé.

Selon un premier mode de réalisation de l'invention, le support secondaire est constitué par une plaquette en un matériau isolant électrique et conducteur thermique, tel que de l'oxyde de Béryllium, qui porte sur une de ses faces principales le résonateur piézoélectrique et sur l'autre face principale le circuit intégré.

Le circuit intégré et le boîtier du résonateur sont situés en regard l'un de l'autre de part et d'autre de la plaquette de support secondaire et sont fixés sur celle-ci à l'aide d'une colle assurant un bon contact thermique.

De façon plus particulière, la plaquette de support secondaire comprend sur sa face portant le circuit intégré des parties métallisées par sérigraphie formant bornes de contact et reliées d'une part au circuit intégré par des premiers fils de liaison et, d'autre part, au circuit imprimé par des seconds fils de liaison en un matériau mauvais conducteur thermique.

Selon un autre mode de réalisation de l'invention, le support secondaire est constitué directement par le boîtier du résonateur piézoélectrique, sur lequel est rapporté et fixé le circuit intégré, et qui repose en un petit nombre de points sur le rebord de l'ouverture ménagée dans le circuit imprimé.

L'oscillateur peut comprendre un boîtier étanche muni de plusieurs bornes de sortie, à l'intérieur duquel sont disposés à la fois le circuit intégré et le résonateur, ledit boîtier reposant sur le rebord de l'ouverture du circuit imprimé et étant raccordé électriquement à celui-ci pas ses bornes de sortie.

De préférence, l'oscillateur comprend en outre, des moyens de commande de fréquence de l'oscillateur constitués par des composants discrets rapportés sur le support secondaire.

Selon une caractéristique particulièrement avantageuse de la présente invention, les moyens de régulation de la température du résonateur comprennent un thermostat interne comportant un capteur de température, un circuit comparateur et des transistors de chauffage intégrés sur le circuit intégré.

Le thermostat interne peut en outre comprendre une résistance d'ajustage de la température interne de référence et une résistance d'ajustage du courant dans les transistors de chauffage, qui sont constituées par des composants discrets placés sur le circuit imprimé.

Le thermostat interne peut aussi comprendre un circuit de contre-réaction constitué de composants discrets placés sur le circuit imprimé.

Selon encore une autre caractéristique avantageuse de l'invention, les moyens de régulation de la température du résonateur comprennent en outre un amplificateur différentiel formant comparateur intégré sur le circuit intégré et coopérant avec un capteur de température et des transistors de chauffage constitués par des composants discrets placés sur le circuit imprimé pour former un thermostat externe de mise en température rapide de l'oscillateur.

L'oscillateur thermostaté miniature selon l'invention peut encore comprendre un boîtier étanche muni de bornes de sortie à l'intérieur duquel est placé le support de montage comprenant le circuit imprimé et ledit support secondaire, et dans lequel on peut faire le vide.

D'autres caractéristiques et avantages de l'invention ressortiront de la description suivante de modes particuliers de réalisation de l'invention, donnés à titre d'exemples non limitatifs, en référence aux dessins annexés, sur lesquels :

— la figure 1 est une vue de dessus d'un support intermédiaire recevant un circuit prédiffusé et un résonateur piézoélectrique miniature et destiné à être incorporé dans un oscillateur selon l'invention,

— la figure 2 est une vue de dessus d'un exemple d'oscillateur selon l'invention comportant un support de montage sur lequel est disposé un support intermédiaire tel que le support intermédiaire de la figure 1,

— la figure 3 est une vue en coupe selon la ligne III-III de la figure 2,

— la figure 4 représente le schéma d'un exemple de circuits électroniques pouvant être mis en oeuvre dans le cadre d'un oscillateur thermostaté selon l'invention, et

— les figures 5 et 6 sont des vues en perspective de deux autres types de supports intermédiaires constitués par des boîtiers de résonateur et pouvant être substitués au support de la figure 2.

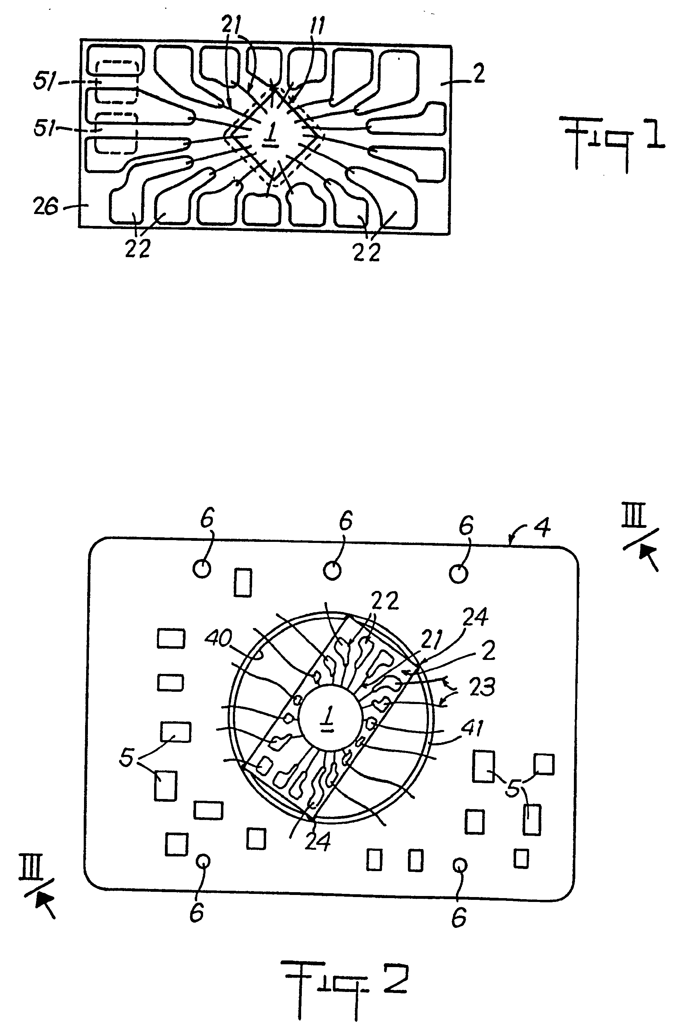

Les figures 1 à 3 montrent l'aspect mécanique d'un oscillateur thermostaté miniature réalisé conformément à un premier mode de réalisation de l'invention.

L'oscillateur, qui peut en outre être disposé dans un boîtier étanche, non représenté, dans lequel on a fait le vide, comprend un support principal de montage constitué par une plaque 4 de circuit imprimé sur laquelle sont disposées de façon classique des pistes métalliques conductrices, non représentées, servant de conducteurs de liaison pour différents composants discrets 5 tels que des résistances ou des condensateurs, montés sur la plaque 4. Des bornes 6 de sortie de l'oscillateur sont également réalisées de façon classique sur la plaque 4.

Une ouverture 40, par exemple circulaire, est réalisée dans la partie centrale de la plaque 4 pour permettre l'insertion d'un support secondaire 2 constitué par une plaquette en matériau conducteur thermique et isolant électriquement tel que de l'oxyde de béryllium. La paroi de l'ouverture 40 définit un rebord 41 en forme de gradin sur lequel viennent reposer les quatre angles 24 de la plaquette secondaire 2. La plaquette secondaire 2 peut ainsi être fixée à la plaque 4 de circuit imprimé, par exemple par collage, en un petit nombre de points, ce qui limite les ponts thermiques entre la plaquette isolante 2 et le support principal de montage 4.

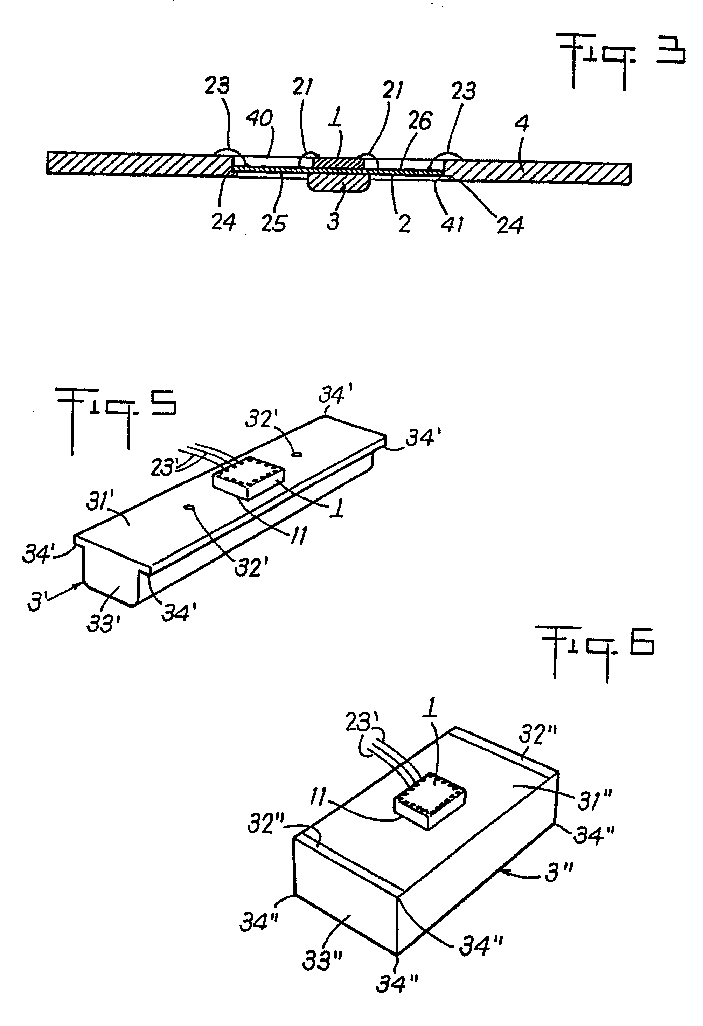

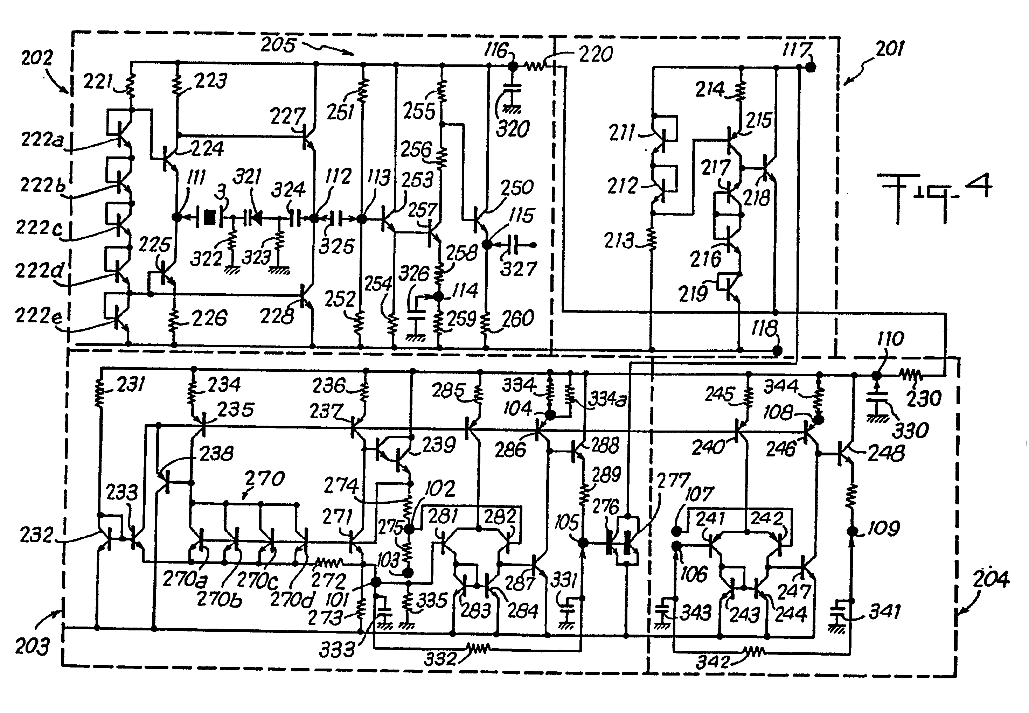

La plaquette 2 en oxyde de béryllium porte sur l'une de ses faces 26 un circuit intégré, ou "puce", avantageusement constitué par un circuit prédiffusé 1. Le circuit prédiffusé 1 est fixé au centre de la plaquette 2 à l'aide d'une couche de colle 11 assurant un bon contact thermique. Un résonateur piézoélectrique miniature 3, par exemple un résonateur à quartz, est fixé sur la face opposée 25 de la plaquette 2, dans la partie centrale de celle-ci, de manière à être située le plus près possible du circuit prédiffusé 1. Avec une telle structure en sandwich, représentée sur la figure 3, le gradient de température entre le résonateur 3 et le circuit prédiffusé 1 peut être très réduit.

Une couche épaisse d'or peut être déposée par sérigraphie sur la face 26 de la plaquette 2 en des zones localisées 22 à la périphérie de la plaquette 2 pour former des bornes de contact reliées au circuit prediffusé 1 par des fils de liaison 21. Des condensateurs 51 ou autres élements d'ajustage de la fréquence du résonateur 3 peuvent en outre être disposés sur la plaquette 2 entre certaines des bornes 22, ou être placés directement sur le bottier du résonateur 3 fixe sur la face 25 de la plaquette 2 en BeO.

Des fils de liaison 23, en un matériau bon conducteur électrique, mais mauvais conducteur thermique relient les bornes 22 formées sur la plaquette 2 à diverses pistes conductrices du circuit imprimé 4. Les fils de liaison 23 peuvent être réalisés par exemple dans le matériau connu sous la dénomination tophet ou en acier inoxydable.

Selon d'autres modes de réalisation possibles représentés sur les figures 5 et 6, le support secondaire destiné à être fixé en un nombre limité de points sur le rebord 41 de l'ouverture 40 de la plaque 4 de circuit imprimé peut être constitué directement par le boîtier 3′ respectivement 3″ du résonateur 3, ce qui évite l'utilisation d'un support intermédiaire tel que la plaquette 2 du mode de réalisation des figures 1 à 3.

La figure 5 montre un résonateur 3 incorporé dans un boîtier 3′ de type baignoire, qui présente des faces latérales d'extrémité 33′ en forme de T et une face plane 31′ correspondant à la branche horizontale du T. Des bornes de sortie 32′ sont formées dans la face 31′, mais pourraient naturellement être formées également dans les faces latérales 33′. Le circuit prédiffusé 1 est directement fixé sur la face plane 31′ du boîtier 3′, par exemple à l'aide d'une couche de colle 11 assurant un bon transfert thermique. Ce mode de réalisation permet d'avoir un excellent échange thermique entre le circuit prédiffusé 1 et le résonateur 3 incorporé dans le boîtier 3′. En effet, le thermostat intégré dans le circuit prédiffusé 1 est dans ce cas placé au plus près du résonateur 3. Le boîtier 3′ est destiné à reposer sur le rebord 41 de l'ouverture 40 de la plaque 4 par les coins 34′ de la face plane 31′ constituant la branche horizontale du T. La face 31′ joue ainsi le même rôle que la plaquette 2 des figures 1 à 3, et les échanges d'énergie thermique entre le boîtier 3′ et la plaque 4 de circuit imprimé sont réduits au minimum puisque le boîtier 3′ n'est en contact qu'en quatre points avec la plaque 4 et la fixation du boîtier 3′ peut être réalisée avec une colle constituant un mauvais conducteur thermique.

La figure 6 montre une variante de réalisation dans laquelle le boîtier 3″ du résonateur 3 est du type céramique et présente une forme parallélépipédique avec des faces d'extrémité rectangulaires 34″ et une face plane principale 31″ portant le long de deux de ses côtés opposés des bornes 32″ de sortie du résonateur 3 situé à l'intérieur du boîtier 3″. Le circuit prédiffusé 1 est fixé directement par collage sur la face plane 31″ du boîtier 3″ ce qui conduit aux mêmes avantages que dans le cas du mode de réalisation de la figure 5. Le boîtier 3″ est destiné à reposer sur le rebord 41 de l'ouverture 40 du circuit imprimé 4 par ses angles 34″ situés sur la face plane principale opposée à la face 31″ portant le circuit prédiffusé 1. Comme dans le cas du montage de la figure 5, des fils de connexion 23′, par exemple en aluminium, relient directement le circuit prédiffusé 1 aux pistes conductrices du circuit imprimé 4.

A titre de variante, le circuit intégré 1 peut encore être fixé à l'intérieur même du boîtier du résonateur, soit directement sur le résonateur, soit sur une face interne du boîtier du résonateur. Dans ce cas, le boîtier du résonateur possède plusieurs bornes de sortie permettant toutes les liaisons nécessaires entre le circuit intégré et les circuits externes au boîtier constitués par le circuit imprimé 4. Le boîtier étanche est de préférence prévu pour que l'on puisse faire le vide à l'intérieur.

On décrira maintenant en référence à la figure 4 un exemple de circuits électroniques utilisables dans le cadre de la présente invention.

La plupart des composants figurant sur le schéma de la ligure 4 sont intégrés au sein du circuit prédiffusé 1, ce qui conduit à une grande compacité de l'oscillateur dans son ensemble et surtout, comme cela a été expliqué précédemment, permet aux éléments de circuit d'être située au plus près du résonateur 3. Sur la figure 4, les bornes du circuit permettant l'alimentation du dispositif à partir d'une source extérieure de tension non régulée, le prélèvement des signaux de sortie utiles, et le raccordement des composants discrets 5 de la figure 2 situés sur le circuit imprimé 4 sont désignés par les numéros de référence 101 à 118. Pour faciliter la description, les composants intégrés au sein du circuit prédiffusé 1 portent des numéros de référence à trois chiffres dont le premier est un 2 tandis que les composants discrets extérieurs au circuit prédiffusé 1 et placés soit sur le circuit imprimé 4, soit sur le boîtier du résonateur 3, soit sur la plaquette en oxyde de béryllium 2 portent des numéros de référence à trois chiffres dont le premier est un 3.

L'ensemble du circuit représenté sur la figure 4 peut être divisé en plusieurs sous-ensembles fonctionnels désignés par les références 201 à 205. Pour chacun des sous-ensembles fonctionnels, un petit nombre d'éléments seulement sont constitués par des composants discrets qui consomment relativement peu d'énergie et correspondent essentiellement à des éléments de liaison, d'ajustage ou de contre-réaction. Par suite, la majeure partie de l'énergie dissipée en chaleur au sein des divers sous-ensembles fonctionnels 201 à 205 est dégagée au sein du circuit prédiffusé 1 qui est placé au voisinage immédiat du résonateur 3 et comprend sous forme intégrée un thermostat interne 203. Ceci contribue à améliorer le rendement des échanges thermiques avec le résonateur et à limiter l'énergie nécessaire pour stabiliser la température du résonateur 3, ce qui autorise précisément la réalisation d'un ensemble de circuits électroniques assurant diverses fonctions dont une fonction de thermostat au sein d'un même circuit intégré 1 et permet de réaliser finalement un oscillateur thermostaté qui est de très petites dimensions.

Un aspect important de la présente invention est donc constitué par la combinaison au sein d'un même circuit intégré 1 de plusieurs sous-ensembles fonctionnels 201 à 205 comprenant un premier sous-ensemble 201 constituant un régulateur de la tension d'alimentation du montage, un second sous-ensemble 202, 205 à deux étages comprenant des circuits 202 d'entretien des oscillations du résonateur 3 et des circuits 205 d'amplification des oscillations de l'étage 202, un troisième sous-ensemble 203 constituant un thermostat interne et comprenant notamment sous forme intégrée un capteur de température 270 à 273, un amplificateur différentiel formant comparateur 280 à 289, et des transistors de chauffage 276, 277, et, à titre d'option, un quatrième sous-ensemble 204 comprenant un amplificateur différentiel intégré 240 à 249, analogue à l'amplificateur différentiel intégré 280 à 289, et destiné à constituer un comparateur pour un thermostat externe de mise en température rapide du dispositif comprenant un capteur de température et des moyens de chauffage non intégrés.

Chacun des sous-ensembles 201 à 205 sera maintenant décrit de façon plus détaillée.

Le circuit régulateur de tension 201 est entièrement réalisé au sein du circuit intégré prédiffusé 1 et reçoit une tension d'alimentation continue non régulée, par exemple comprise entre 10 et 20 volts sur la borne 117 d'alimentation générale du dispositif, la borne 118 correspondant elle-même à la borne de masse. La tension continue régulée de sortie du circuit 201, qui est par exemple de 7, 3 volts est appliquée, par l'intermédiaire d'une résistance 220, sur la borne 116 d'alimentation des étages 202 et 205 du sous-ensemble constituant l'oscillateur proprement dit et, par l'intermédiaire d'une résistance 230, sur la borne 110 d'alimentation du thermostat interne 203 et de l'amplificateur différentiel 204 du thermostat externe. Des condensateurs de découplage 320 et 330 constitués par des composants discrets sont disposés entre la masse et les bornes 116 et 110 respectivement.

Le circuit régulateur de tension 201 comprend entre les bornes 117 et 118 une première branche qui comporte successivement deux transistors 211, 212 connectés en diode et montés en série et une résistance 213 connectée entre l'émetteur du second transistor 212 et la masse. Une seconde branche comprend successivement en série entre la borne d'alimentation 117 et la masse une résistance 214, l'espace émetteur-collecteur d'un transistor 215, deux transistors 217, 216 connectés en diodes montées tête-bêche et un transistor 219 monté en diode. La base du transistor 215 est reliée au point de connexion entre l'émetteur du transistor 212 et la résistance 213. Le collecteur du transistor 215, relié à l'émetteur du transistor 217 connecté en diode, est relié à la base du transistor de sortie 218 dont le collecteur est relié à la borne 117 et l'émetteur est relié aux bornes 116 et 110 par l'intermédiaire des résistances 220 et 230 respectivement.

L'oscillateur proprement dit 202, 205 comprend un premier étage 202 d'entretien des oscillations du résonateur 3, lequel étage est constitué par des composants 221, 222a, à 222e et 223 à 228 qui sont intégrés dans le circuit prédiffusé 1. Des composants discrets 321 à 324 permettent en outre d'ajuster la fréquence de l'oscillateur que constitue l'étage 202. Ces composants d'ajustage de fréquence comprennent un condensateur d'accord 324 et une diode à capacité variable 321 montés en série avec le résonateur 3 entre les bornes 111 et 112, ainsi que deux résistances 322, 323 connectées entre la masse et les points communs de connexion respectivement du résonateur 3 et de la diode à capacité variable 321 et de la diode à capacité variable 321 et du condensateur d'accord 324.

Au sein du premier étage 202, la borne 111 est reliée d'une part à l'émetteur d'un premier transistor 224 dont le collecteur est relié par l'intermédiaire d'une résistance 223 à la borne d'alimentation 116, d'autre part au collecteur d'un second transistor 225 dont l'émetteur est relié par l'intermédiaire d'une résistance 226 à la masse. La borne 112 est elle-même reliée d'une part à l'émetteur d'un troisième transistor 227 dont la base est connectée au collecteur du premier transistor 224 et le collecteur est connecté à la borne d'alimentation 116, d'autre part au collecteur d'un quatrième transistor 228 dont l'émetteur est relié à la masse et la base est reliée à la base du second transistor 225 et au collecteur d'un transistor 222e monté en diode et présentant son émetteur connecté à la masse. Quatre transistors montés en diode 222a à 222d sont placés en série entre la base du premier transistor 224 et les bases des second et quatrième transistors 225, 228. Une résistance 221 relie le collecteur du transistor 222a monté en diode à la borne d'alimentation 116.

On voit ainsi qu'un petit nombre de composants intégrés permet l'entretien des oscillations du résonateur 3 tandis que la fréquence des oscillations peut facilement être ajustée à l'aide des composants discrets 321 et 324. La présence du thermostat interne 203 au sein même du circuit prédiffusé 1 et au voisinage immédiat du résonateur 3 garantit une excellente stabilité de la fréquence d'oscillations. Le montage représenté sur la figure 4 est plus particulièrement adapté à des résonateurs dont la fréquence est inférieure à environ 15MHz et dont la résistance est inférieure à environ 100 ohms. Pour des fréquences plus basses, on peut cependant admettre des résistances plus élevées.

Un condensateur de liaison 325 constitué par un composant discret est connecté entre la borne de sortie 112 du premier étage 202 de l'oscillateur 202, 205 et la borne d'entrée 113 de l'étage amplificateur 205. L'étage amplificateur 205 est lui-même classique et comprend sous forme intégrée dans le circuit 1 un premier transistor 253 monté en collecteur commun dont le collecteur est connecté à la borne d'alimentation 116, la base est connectée à la borne d'entrée 113 et l'émetteur est connecté par une résistance 254 à la masse. La base du transistor 253 est reliée par des résistances de polarisation 251, 252 respectivement à la borne 116 et à la masse. Un second transistor 257 a sa base reliée à l'émetteur du premier transistor 253, son collecteur relié à la borne d'alimentation 116 par deux résistances 255, 256 montées en série et son émetteur relié à la masse par deux resistances 258, 259 montées en série. Un transistor de sortie monté en collecteur commun a son collecteur relié à la borne 116, son émetteur relié à la borne de sortie 115 et par une résistance 260 à la masse, et sa base reliée au point commun entre les résistances 255, 256.

Un condensateur de découplage 326 constitué par un composant discret est en outre connecté entre la masse et la borne 114 située au point commun entre les résistances 258 et 259. Un condensateur de liaison 327 est par ailleurs relié à la borne de sortie 115 pour permettre le raccordement direct à un ensemble de traitement ou d'exploitation du signal de sortie de l'oscillateur.

Le thermostat interne 203 comprend des éléments definissant essentiellement un capteur de température, des éléments définissant une tension de référence, un comparateur et des transistors de chauffage. A l'exception d'une résistance d'ajustage 335, le cas échéant d'une résistance d'ajustage 334 montée en parallèle sur une résistance 334a interne au circuit intégré, et d'un circuit de contre-réaction 331 à 333, tous les éléments du circuit 203 de régulation de température sont intégrés dans le circuit 1.

Une première branche connectée entre la borne d'alimentation 110 et la masse comprend une résistance 231 montée en série avec un transistor 232 connecté en diode. Cette branche 231, 232 définit un courant qui au démarrage est absorbé par le transistor 233 dont la base est reliée au collecteur du transistor 232, l'émetteur est relie aux émetteurs de quatre transistors 270a à 270d montés en parallèle et le collecteur est relié aux bases des transistors 235, 237, 280, 286, 240, 246. Le transistor 233 définit ainsi un circuit miroir de courant qui permet la circulation d'un courant identique comprenant respectivement le groupe 270 de transistors en parallèle 270a à 270d, et le transistor 271, et alimentées respectivement par les sources de courant 234, 235 et 236, 237. La source de courant 234, 235 comprend un transistor 235 dont la base est reliée au collecteur du transistor 233, le collecteur est relié aux collecteurs des transistors 270a à 270d et l'émetteur est relié par la résistance 234 à la borne d'alimentation 110. De façon similaire la source de courant 236, 237 comprend un transistor 237 dont la base est reliée au collecteur du transistor 233, le collecteur est relié au collecteur du transistor 271 et l'émetteur est relié par la résistance 236 à la borne 110. Le transistor 238, dont l'émetteur est relié au collecteur du transistor 233, le collecteur est relié à la masse et la base est reliée au collecteur du transistor 235 est prévu pour améliorer la symétrie des courants.

Une résistance 272 est connectée entre les émetteurs des transistors 270a à 270d et l'émetteur du transistor 271 lui-même relié à la masse par une résistance 273. Le point commun entre les résistances 272 et 273 est relié par une borne 101 sur laquelle est disponible une tension proportionnelle à la température interne du circuit intégré 1 définie à partir du capteur de température intégré contitué essentiellement par le groupe de transistors 270. En effet, la surface des émetteurs est dans un rapport de quatre à un entre la branche comprenant le groupe 270 de quatre transistors en parallèle et la branche comprenant un seul transistor 271. Dans la mesure où les sources de courant 234, 235 et 236, 237 débitent des courants identiques, les courants de saturation dans le groupe 270 de quatre transistors et dans le transistor 271 seront dans un rapport de quatre à un compte tenu du rapport des surfaces d'émetteurs. Il s'ensuit qu'une différence de potentiel apparait aux bornes de la résistance 272 et sur la borne 101 il existe une tension dépendant des résistances 272 et 273 et qui varie proportionnellement à la température. A titre d'exemple, la sensibilité au capteur de température 270 à 273 peut être de 2mV par degré Celsius.

Une borne 102 reçoit une tension de référence peu sensible à la température ou aux fluctuations résiduelles de la tension d'alimentation. La borne 102 est reliée par une résistance 274 à l'émetteur d'un ensemble 239 de deux transistors montés en Darlington, dont le collecteur est relié à la borne d'alimentation 110 et la base est reliée au collecteur du transistor 237. Un ensemble de deux résistances 275, 335 montées en série est en outre connecté entre la borne 102 et la masse. Le point commun entre les résistances 275 et 335 est constitué par une borne 103 qui permet d'utiliser une résistance 335 sous la forme d'un composant discret, ce qui permet d'ajuster la tension de préférence sur la borne 102, et donc la température de référence du thermostat. A l'équilibre, les tensions sur les bornes 101 et 102 sont égales ou très voisines. La différence entre les tensions sur les bornes 101 et 102 sert à commander le chauffage réalisé par le montage en parallèle de deux transistors de puissance 276, 277 attaqués en courant et intégrés dans le circuit 1.

Les bornes 101 et 102 sont reliées aux entrées inverseuse et non inverseuse d'un amplificateur différentiel intégré classique 280 à 289, qui sert de comparateur pour délivrer en sortie sur les bases des transistors de puisance 276, 277 un signal de commande de chauffage lorsqu'il y a une inégalité entre les tensions présentes sur les bornes 101 et 102.

L'amplificateur différentiel 280 à 289 comprend une source de courant constituée par le transistor 280 dont la base est reliée au collecteur du transistor 233, l'émetteur est relié par une résistance 285 à la borne d'alimentation 110 et le collecteur est relié aux émetteurs des transistors 281, 282 dont les bases sont reliées aux bornes 101 et 102 respectivement et les collecteurs sont reliés aux collecteurs des transistors 283, 284 dont les émetteurs sont reliés à la masse et les bases sont reliées entre elles. Le collecteur du transistor 283 est relié à sa base tandis que le collecteur du transistor 284, sur lequel apparaît le signal différentiel de sortie est relié à la base d'un transistor 287 dont l'émetteur est relié à la masse et le collecteur est relié au collecteur du transistor 286 dont l'émetteur est relié à la borne 104 permettant la connexion entre les bornes 110 et 104 d'une résistance 334 de limitation de courant dans les transistors de puissance 276, 277. Les bases des transistors de puissance 276, 277 sont en effet reliées par une résistance 289 à l'émetteur d'un transistor 288 dont la base est reliée au collecteur du transistor 286 et le collecteur est relié à la borne 110. Les bases des transistors 276, 277 sont reliées à une borne 105 sur laquelle est disponible le signal de commande de chauffage. Un circuit de contre-réaction composé d'éléments discrets est en outre connecté entre les bornes 101 et 105. Ce circuit comprend une résistance 332 et deux condensateurs 331 et 333. Ces derniers sont connectés entre la masse et respectivement les bornes 105 et 101.

Le sous-ensemble 204 constitue un circuit supplémentaire permettant, à la mise en route de l'oscillateur, un chauffage rapide de ce dernier. Le sous-ensemble 204 comprend des bornes 106, 107, 108, 109 dont les rôles sont tout à fait analogues respectivement à ceux des bornes 101, 102, 104, 105 du thermostat interne 203. Les composants 240 à 249 de l'amplificateur différentiel du circuit 204 sont également tout à fait analogues aux éléments correspondants 280 à 289 de l'amplificateur différentiel du thermostat interne 203 et sont également intégrés sur le même circuit prédiffusé 1. La résistance de limitation du courant 344 joue le même rôle que la résistance de limitation 334 et est également constituée par un composant discret et les éléments 341 à 343 du circuit de contre-réaction connecté entre les bornes 109 et 106 présentent la même structure que les éléments 331 à 333 du circuit de contre-réaction connecté entre les bornes 105 et 101.

La borne 106 permet le raccordement d'un capteur de température externe au circuit prédiffusé 1, lequel capteur peut comprendre par exemple une thermistance. La borne 107 permet le raccordement de composants définissant une référence de tension et jouant le rôle des éléments 233, 274, 275, 235 du thermostat interne 203. Enfin, la borne 109 permet le raccordement de transistors ou résistances de chauffage extérieurs au circuit intégré 1 et jouant le rôle des transistors 276, 277 du thermostat 203.

L'oscillateur thermostaté selon l'invention, tel que représenté sur la figure 2 et avec tous les éléments des circuits électroniques de la figure 4, peut présenter un très faible volume total. A titre d'exemple, un oscillateur selon l'invention a été réalisé avec une plaquette 2 d'oxyde de beryllium d'une largeur d'environ 6 mm et d'une longueur d'environ 12 mm, placée dans l'ouverture 40 d'un circuit imprimé 4 dont les dimensions sont d'environ 3 cm × 2 cm. Les fils de liaison 23 ont eux-mêmes été constitués par des fils de tophet présentant un diamètre de 50 microns. Dans le cas d'un oscillateur selon les modes de réalisation des figures 5 et 6, les fils de liaison 23' peuvent être réalisés en aluminium et peuvent présenter un diamètre de 25 microns.

## Revendications

1. Oscillateur thermostaté miniature, comprenant un support de montage (4), un résonateur piézoélectrique (3), des circuits électroniques (201) de régulation de la tension d'alimentation de l'oscillateur, des circuits électroniques d'entretien (202) et d'amplification (205) des oscillations du résonateur (3), et des moyens (203, 204) de régulation de la température du résonateur piézoélectrique (3), ces derniers étant disposés au voisinage immédiat du résonateur, caractérisé en ce que le support de montage (4) comprend un circuit imprimé muni d'une ouverture (40) sur le rebord de laquelle est fixé en un nombre de points réduit (24 ; 34' ; 34") un support secondaire (2 ; 3' ; 3") isolant électriquement sur lequel sont fixés d'une part le résonateur piézoélectrique (3) et d'autre part un circuit intégré (1) comprenant sous forme intégrée sur une même pastille les éléments essentiels des circuits électroniques (201) de régulation de la tension d'alimentation de l'oscillateur, des circuits électroniques d'entretien (202) et d'amplification (205) des oscillations du résonateur (3) et des moyens (203, 204) de régulation de la température du résonateur piézoélectrique (3).

2. Oscillateur selon la revendication 1, caractérisé en ce que le support secondaire est constitué par une plaquette en un matériau isolant électrique et conducteur thermique qui porte sur une de ses faces principales (25) le résonateur piézoélectrique (3) et sur l'autre face principale (26) le circuit intégré (1).

3. Oscillateur selon la revendication 2, caractérisé en ce que le support secondaire est constitué par une plaquette d'oxyde de Béryllium.

4. Oscillateur selon la revendication 2 ou la revendication 3, caractérisé en ce que le circuit intégré (1) et le boîtier du résonateur (3) sont situés en regard l'un de l'autre de part et d'autre de la plaquette de support secondaire (2) et sont fixés sur celle-ci à l'aide d'une colle assurant un bon contact thermique.

5. Oscillateur selon l'une quelconque des revendications 2 à 4, caractérisé en ce que la plaquette de support secondaire (2) comprend sur sa face portant le circuit intégré (1) des parties (22) métallisées par sérigraphie formant bornes de contact et reliées d'une part au circuit intégré (1) par des premiers fils de liaison (21) et, d'autre part, au circuit imprimé (4) par des seconds fils de liaison (23) en un matériau mauvais conducteur thermique.

6. Oscillateur selon la revendication 1, caractérisé en ce que le support secondaire (3' ; 3") est constitué directement par le boîtier (3' ; 3") du résonateur piézoélectrique (3), sur lequel est rapporté et fixé le circuit intégré (1), et qui repose en un petit nombre de points (34' ; 34") sur le rebord (41) de l'ouverture (40) ménagée dans le circuit imprimé (4) ou se trouve relié à ce dernier par les fils de connexion du résonateur (3) reliés aux bornes de sortie (32') de celui-ci.

7. Oscillateur selon la revendication 6, caractérisé en ce qu'il comprend un boîtier étanche muni de plusieurs bornes te sortie, à l'intérieur duquel sont disposés à la fols le circuit intégré (1) et le résonateur (3), et en ce que ledit boîtier repose sur le rebord de l'ouverture (40) du circuit imprimé (4), et est raccordé électriquement à ce dernier par ses bornes de sortie.

8. Oscillateur selon l'une quelconque des revendications 1 à 7, caractérisé en ce qu'il comprend en outre des moyens (321 à 324) de commande de fréquence de l'oscillateur constitués par des composants discrets rapportés sur le support secondaire (2 ; 3' ; 3").

9. Oscillateur selon l'une quelconque des revendications 1 à 8, caractérisé en ce que les moyens (203, 204) de régulation de la température du résonateur (3) comprennent un thermostat interne (203) comportant un capteur de température (270, 271, 272), un circuit comparateur (280 à 289) et des transistors de chauffage (276, 277) intégrés sur le circuit intégré (1).

10. Oscillateur selon la revendication 9, caractérisé en ce que le thermostat interne (203) comprend en outre une résistance (335) d'ajustage de la température interne de référence, laquelle résistance est constituée par un composant discret placé sur le circuit imprimé (4).

11. Oscillateur selon l'une quelconque des revendications 9 et 10, caractérisé en ce que le thermostat interne (203) comprend en outre une résistance (334) d'ajustage du courant dans les transistors de chauffage (276, 277), laquelle résistance est constituée par un composant discret placé sur le circuit imprimé (4).

12. Oscillateur selon l'une quelconque des revendications 9 à 11, caractérisé en ce que le thermostat interne (203) comprend en outre un circuit de contre-réaction (331 à 333) constitué de composants discrets placés sur le circuit imprimé (4).

13. Oscillateur selon l'une quelconque des revendications 1 à 12, caractérisé en ce que les moyens (203, 204) de régulation de la température du résonateur (3) comprennent en outre un amplificateur différentiel formant comparateur (240 à 249) intégré sur le circuit intégré (1) et coopérant avec un capteur de température et des transistors de chauffage constitués par des composants discrets placés sur le circuit imprimé (4) pour former un thermostat externe de mise en température rapide de l'oscillateur.

14. Oscillateur selon l'une quelconque des revendications 1 à 13, caractérisé en ce qu'il comprend un boîtier étanche muni de bornes de sortie à l'intérieur duquel est placé le support de montage (4) comprenant le circuit imprimé et ledit support secondaire (2, 3', 3").

## Ansprüche

1. Thermostatgeregelter Miniaturoszillator, mit einem Montageträger (4), einem piezoelektrischen Resonator (3), elektronischen Schaltungen (201) zur Steuerung der Versorgungsspannung des Oszillators, elektronischen Schaltungen zum Halten (202) und Verstärken (205) der Schwingungen des Resonators (3) und Mitteln (203, 204) zur Steuerung der Temperatur des piezoelektrischen Resonators (3), wobei diese letzteren in der unmittelbaren Umgebung des Resonators angeordnet sind, dadurch gekennzeichnet, daß der Montageträger (4) eine gedruckte Schaltung umfaßt, die mit einer Öffnung (40) versehen ist, an deren Rand an einer beschränkten Anzahl von Punkten (24 ; 34' ; 34") ein sekundärer Träger (2; 3' ; 3") befestigt ist, auf dem elektrisch isoliert einerseits der piezoelektrische Resonator (3) und andererseits eine integrierte Schaltung (1), die in integrierter Form auf demselben Substrat die wesentlichen Elemente der elektronischen Schaltungen (201) zur Steuerung der Versorgungsspannung des Oszillators, der elektronischen Schaltungen zum Halten (202) und Verstärken (205) der Schwingungen des Resonators (3) und der Mittel (203, 204) zur Steuerung der Temperatur des piezoelektrischen Resonators (3) umfaßt, befestigt sind.

2. Oszillator gemäß Anspruch 1, dadurch gekennzeichnet, daß der sekundäre Träger durch ein Plättchen aus elektrisch isolierendem und wärmeleitenden Material gebildet ist, das auf einer seiner Hauptseiten (25) den piezoelektrischen Resonator (3) und auf der anderen Hauptseite (26) die integrierte Schaltung (1) trägt.

3. Oszillator gemäß Anspruch 2, dadurch gekennzeichnet, daß der sekundäre Träger durch ein Plättchen aus Berylliumoxid gebildet wird.

4. Oszillator gemäß Anspruch 2 oder Anspruch 3, dadurch gekennzeichnet, daß die integrierte Schaltung (1) und das Resonatorgehäuse (3) einander gegenüberliegend auf beiden Seiten des Plättchens des sekundären Trägers (2) angeordnet und auf diesem mit Hilfe eines einen guten thermischen Kontakt gewährleistenden Klebstoffs befestigt sind.

5. Oszillator gemäß einem der Ansprüche 2 bis 4, dadurch gekennzeichnet, daß das Plättchen des sekundären Trägers (2) auf seiner die integrierte Schaltung (1) tragenden Seite durch Siebdruck metallisierte, Kontaktanschlüsse bildende Teile (22) umfaßt, die einerseits durch erste Drahtbrücken mit der integrierten Schaltung (1) und andererseits durch zweite Drahtbrücken (23) aus schlecht wärmeleitendem Material mit der gedruckten Schaltung (4) verbunden sind.

6. Oszillator gemäß Anspruch 1, dadurch gekennzeichnet, daß der sekundäre Träger (3' ; 3") direkt durch das Gehäuse (3' ; 3") des piezoelektrischen Resonators (3) gebildet wird, auf dem die integrierte Schaltung (1) aufgetragen und befestigt ist und der mit einer kleinen Anzahl von Punkten (34' ; 34") auf der Kante (41) der in der gedruckten Schaltung (4) vorgesehenen Öffnung (40) ruht oder mit der gedruckten Schaltung (4) durch Verbindungsdrähte des Resonators (3), die mit dessen Ausgangsanschlüssen (32') verbunden sind, verbunden ist.

7. Oszillator gemäß Anspruch 6, dadurch gekennzeichnet, daß er ein dichtes Gehäuse umfaßt, das mit einer Mehrzahl von Ausgangsanschlüssen versehen ist und in dessen Innerem sowohl die integrierte Schaltung (1) als auch der Resonator (3) angeordnet sind, und daß das Gehäuse auf dem Rand der Öffnung (40) der gedruckten Schaltung (4) ruht und mit der letzteren durch seine Ausgangsanschlüsse elektrisch verbunden ist.

8. Oszillator gemäß einem der Ansprüche 1 bis 7, dadurch gekennzeichnet, daß er außerdem Mittel (321-324) zum Steuern der Frequenz des Oszillators umfaßt, die durch auf dem zweiten Träger (2 ; 3' ; 3") aufgetragene diskrete Bauelemente gebildet werden.

9. Oszillator gemäß einem der Ansprüche 1 bis 8, dadurch gekennzeichnet, daß die Mittel (203, 204) zum Steuern der Temperatur des Resonators (3) einen internen Thermostat (203) umfassen, der einen Temperatursensor (270, 271, 272), eine Vergleichsschaltung (280 bis 289) und in die integrierte Schaltung (1) integrierte Heiztransistoren (276, 277) enthält.

10. Oszillator gemäß Anspruch 9, dadurch gekennzeichnet, daß der interne Thermostat (203) außerdem einen Widerstand (335) zum Einstellen der internen Referenztemperatur umfaßt, wobei der Widerstand durch ein auf der gedruckten Schaltung (4) angeordnetes diskretes Bauelement gebildet wird.

11. Oszillator gemäß einem der Ansprüche 9 und 10, dadurch gekennzeichnet, daß der interne Thermostat (203) außerdem einen Widerstand (334) zum Einstellen des Stroms in den Heiztransistoren (276, 277) umfaßt, wobei der Widerstand durch ein auf der gedruckten Schaltung (4) angeordnetes diskretes Bauelement gebildet wird.

12. Oszillator gemäß einem der Ansprüche 9 bis 11, dadurch gekennzeichnet, daß der interne Thermostat (203) außerdem eine Rückkopplungsschaltung (331-333) umfaßt, die durch auf der gedruckten Schaltung (4) angeordnete diskrete Bauelemente gebildet wird.

13. Oszillator gemäß einem der Ansprüche 1 bis 12, dadurch gekennzeichnet, daß die Mittel (203, 204) zum Steuern der Temperatur des Resonators (3) außerdem einen Differenzverstärker umfassen, der einen auf der integrierten Schaltung (1) integrierten Komparator (240-249) bildet und mit einem Temperatursensor und Heiztransistoren zusammenwirkt, die durch auf der gedruckten Schaltung (4) angeordnete diskrete Bauelemente gebildet werden, um einen externen Thermostat zum schnellen Aufheizen des Oszillators zu bilden.

14. Oszillator gemäß einem der Ansprüche 1 bis 13, dadurch gekennzeichnet, daß er ein mit Ausgangsanschlüssen versehenes dichtes Gehäuse umfaßt, in dessen Innerem der die gedruckte Schaltung und den sekundären Träger (2, 3', 3") umfassende Montageträger (4) angeordnet ist.

## Claims

1. Miniature thermostatted oscillator, comprising, a mounting support (4), a piezo-electric resonator (3), electronic circuits (201) for regulating the supply voltage of the oscillator, electronic circuits for maintaining (202) and amplifying (205) the oscillations of the resonator (3), and means (205) for regulating the temperature of the piezo-electric resonator (3), the latter being disposed in the immediate vicinity of the resonator, characterized in that the mounting support (4) comprises a printed circuit provided with an opening (40) or the edge of which is fixed, at a reduced number of points (24 ; 34' ; 34), an electrically insulating secondary support (2 ; 3', 3") on which are fixed, on the one hand, the piezo-electric resonator (3) and, on the other hand, an integrated circuit (1) comprising in integrated form on the same chip, the essential elements of the electronic circuits (201) for regulating the supply voltage of the oscillator, of the electronic circuits for maintaining (202) and amplifying (205) the oscillations of the resonator (3), and of the means (203, 204) for regulating the temperature of the piezo-electric resonator (3).

2. Oscillator according to claim 1, characterized in that the secondary support is constituted by a wafer made of an electrically insulating and heat-conducting material, which bears on one of its principal faces (25) the piezo-electric resonator (3) and on the other principal face (26) the integrated circuit (1).

3. Oscillator according to claim 2, characterized in that the secondary support is constituted by a wafer of beryllium oxide.

4. Oscillator according to claim 2 or claim 3, characterized in that the integrated circuit (1) and the package of the resonator (3) are located opposite each other on either side of the secondary support wafer (2) and are fixed thereon with the aid of an adhesive ensuring good thermal contact.

5. Oscillator according to any one of claims 2 to 4, characterized in that the secondary support wafer (2) comprises on its face bearing the integrated circuit (1) parts (22) metallized by screen process printing forming contact terminals and connected, on the one hand, to the integrated circuit (1) by first connecting wires (21) and, on the other hand, to the printed circuit (4) by second connecting wires (23) made of a material which is poor conductor of electricity.

6. Oscillator according to claim 1, characterized in that the secondary support (3', 3") is directly constituted by the package (3' ; 3") of the piezo-electric resonator (3), to which is added and fixed the integrated circuit (1), and which rests at a small number of points (34' ; 34") on the edge (41) of the opening (40) made in the printed circuit (4), or is connected to the latter by the connecting wires of the resonator (3) connected to the output terminals (32') thereof.

7. Oscillator according to claim 6, characterized in that it comprises a sealed package provided with a plurality of output terminals, inside which are disposed both the integrated circuit (1) and the resonator (3), and in that said package rests on the edge (40) of the opening (4) of the printed circuit and is electrically connected thereto by its output terminals.

8. Oscillator according to any one of claims 1 to 7, characterized in that it further comprises means (321 to 324) for controlling the frequency of the oscillator, constituted by discrete components provided on the secondary support (2 ; 34 ; 3").

9. Oscillator according to any one of claims 1 to 8, characterized in that the means (203, 204) for regulating the temperature of the resonator (3) comprise an internal thermostat (203) comprising a temperature sensor (270, 271, 272), a comparator circuit (280 to 289) and heating transistors (276, 277) integrated on the integrated circuit (1).

10. Oscillator according to claim 9, characterized in that the internal thermostat (203) further comprises a resistor (335) for adjusting the internal reference temperature, which resistor is constituted by a discrete component placed on the printed circuit (4).

11. Oscillator according to any one of claims 1 to 13, characterized in that the internal thermostat (203) further comprises a resistor (334) for adjusting the current in the heating transistors (276, 277) which resistor is constituted by a discrete component placed on the printed circuit (4).

12. Oscillator according to any one of claims 9 and 10, characterized in that the internal thermostat (203) further comprises a negative feedback circuit (331 to 333) constituted by discrete components placed on the printed circuit (4).

13. Oscillator according to any one of claims 1 to 12, characterized in that the means (203, 204) for regulating the temperature of the resonator (3) further comprise a differential amplifier forming comparator (240 to 244) integrated on the integrated circuit (1) and cooperating with a temperature sensor and heating transistors constituted by discrete components placed on the printed circuit (4) to form an external thermostat for rapidly heating the oscillator.

14. Oscillator according to any one of claims 1 to 13, characterized in that it comprises a sealed package provided with output terminals inside which is placed the mounting support (4) comprising the printed circuit and said secondary support (2, 3', 3").

Fig 1

Fig 2

Fig. 3

Fig. 5

Fig. 6

Fig. 4